# EUROPEAN PATENT SPECIFICATION

(11) **EP 4 700 580 B1**
(45) Date of publication and mention of the grant of the patent: **26.08.2026**
(21) Application number: 25197566.0
(22) Date of filing: 22.08.2025
(51) Int. Cl.: G06F 11/00, G06F 11/10, G06F 12/02, G06F 3/06

(54) **METHOD FOR WRITING DATA TO STORAGE WITH VARIABLE CODE RATE-BASED ON STORAGE USAGE AND CONDITION**
VERFAHREN ZUM SCHREIBEN VON DATEN IN EINEN SPEICHER MIT VARIABLER CODERATE AUF BASIS VON SPEICHERNUTZUNG UND -BEDINGUNG
PROCÉDÉ D'ÉCRITURE DE DONNÉES DANS UN STOCKAGE À DÉBIT DE CODE VARIABLE SUR LA BASE DE L'UTILISATION ET DE L'ÉTAT DU STOCKAGE

(30) Priority: 23.08.2024 IN 202441063866; 11.06.2025 IN 202441063866
(43) Date of publication of application: 25.02.2026
(73) Proprietor: Samsung Electronics Co., Ltd., Suwon-si, Gyeonggi-do 16677 (KR)
(72) Inventor: TANGELLA, Manoj Kumar, 560048 Bengaluru (IN); BALAKRISHNAN, Rakesh, 560048 Bengaluru (IN)
(74) Representative: Marks & Clerk LLP

(56) References cited:
- US-A1- 2016 357 776
- US-A1- 2020 150 899
- US-A1- 2023 280 940

## Description

### BACKGROUND

One or more example embodiments are related to the general field of data storage, and more particularly, but not exclusively to a storage device, a system including the storage device, a method for writing data in the storage device, and/or non-transitory computer readable medium storing computer executable instructions for executing the method, etc.

Storage devices, such as portable Solid-State Drives (SSDs), etc., are used to store data. Most portable SSDs are used with limited workloads and fill factor, and many users do not completely fill portable SSD devices with data and therefore do not completely utilize the available space and/or memory. It is also a common scenario for the portable SSDs to be in an idle power OFF state for a long time before performing any Input/Output (I/O) operations. However, portable SSDs made with Quad-Level Cell (QLC) technology are prone to high read errors and have less data retention power (e.g., data retention reliability, etc.) in comparison to Triple-Level Cell (TLC) SSD technology and/or Multi-level Cell (MLC) SSD technology, etc. Further, when portable SSDs made with QLC technology are left idle for a long time period without any I/O activity, device firmware policies, like Patrol Read and Random Interval Neighbor Check (RINC), etc., become less effective. For these policies to work properly, portable SSDs made with QLC technology must be powered on and must be active regularly. Another scenario is when an Operating System (OS) is factory installed on a laptop (or other computing device) during assembly and remains powered down in the warehouse for a long time period before its next power on operation. In such situations, data written in SSDs which are powered down for a long time period are prone to high read errors and/or has less data retention power and/or reliability, etc.

US 2020/150899 A1 discloses increasing the number of parity bits in order to increase the reliability of the storage device.

US 2016/357776 A1 discloses increasing write amplification due to increased parity overhead.

The information disclosed in this background section is only for enhancement of understanding of the general background of the example embodiments of the inventive concepts and should not be taken as an acknowledgement or any form of suggestion that this information forms the prior art already known to a person of ordinary skill in the art.

### SUMMARY

The invention is set out in the appended set of claims. The dependent claims set out particular embodiments.

Some example embodiments of the inventive concepts relate to a method for writing data in a storage device. The method includes determining, by the storage device, a Write Amplification Factor (WAF) value and a fill factor value associated with the storage device in response to a write request, fetching, by the storage device, a current parity mode value of the storage device, determining, by the storage device, a WAF threshold and a fill factor threshold associated with the current parity mode value, determining, by the storage device, whether to change the current parity mode value to a higher parity mode value of a plurality of parity mode values based on the WAF threshold, the WAF value, the fill factor threshold, and the fill factor value, and writing, by the storage device, data in a storage area of the storage device based on results of the determining.

Some example embodiments of the inventive concepts relate to a storage device. The storage device comprises processing circuitry and a memory communicatively coupled to the processing circuitry, wherein the memory is configured to store computer executable instructions, which when executed, cause the processing circuitry to, determine a Write Amplification Factor (WAF) value and a fill factor value associated with the storage device in response to a write request, fetch a current parity mode value of the storage device, determine a WAF threshold and a fill factor threshold associated with the current parity mode value, determine whether to change the current parity mode value to a higher parity mode value of a plurality of parity mode values based on the WAF value, the WAF threshold, the fill factor value, and the fill factor threshold, and write data in a storage area of the storage device based on results of the determining.

Some example embodiments of the inventive concepts relate to a storage device. The storage device comprises processing circuitry, and memory configured to store computer executable instructions, which when executed, causes the processing circuitry to, receive a write request, determine whether a trigger has been reached based on the write request, in response to the trigger being reached, determine a Write Amplification Factor (WAF) value and a fill factor value associated with the storage device, determine a WAF threshold and a fill factor threshold based on a current parity mode value of the storage device, determine whether to change the current parity mode value to a higher parity mode value of a plurality of parity mode values based on the WAF threshold, the WAF value, the fill factor threshold, and the fill factor value, and write data in a storage area of the storage device based on results of the determining.

At least some of the above and other features of the invention are set out in the claims.

The foregoing summary is illustrative only and is not intended to be in any way limiting. In addition to the illustrative aspects, example embodiments, and features described above, further aspects, example embodiments, and features will become apparent by reference to the drawings and the following detailed description.

### BRIEF DESCRIPTION OF THE DRAWINGS

The accompanying drawings, which are incorporated in and comprise a part of this disclosure, illustrate some example embodiments and together with the description, serve to explain the inventive concepts. In the figures, the left-most digit(s) of a reference number identifies the figure in which the reference number first appears. The same numbers are used throughout the figures to reference like features and components. Some examples of devices, systems, and/or methods in accordance with one or more example embodiments of the inventive concepts are now described below, by way of example only, and with reference to the accompanying figures.
FIG. 1a illustrates an environment for writing data in a storage device in accordance with some example embodiments of the inventive concepts.
FIG. 1b illustrates an example of a parity mode values table in accordance with some example embodiments of the inventive concepts.
FIG. 1c to FIG. 1d illustrate examples of block allocation based on parity mode values in accordance with some example embodiments of the inventive concepts.
FIG. 2 shows a detailed block diagram of a storage device in accordance with some example embodiments of the inventive concepts.
FIGS. 3a and 3b illustrate flowcharts showing a method for writing data in a storage device in accordance with some example embodiments of the inventive concepts.
FIG. 4 illustrates comparative examples of parity mode values for a conventional storage device and parity mode values for at least one example embodiment of the inventive concepts.
FIGS. 5a to 5c illustrate use case examples of a method for writing data in a storage device in accordance with some example embodiments of the inventive concepts.

It should be appreciated by those of ordinary skill in the art that any block diagrams herein represent conceptual views of illustrative systems embodying the principles of the example embodiments of the inventive concepts. Similarly, it will be appreciated that any flowcharts, flow diagrams, state transition diagrams, pseudo code, and the like represent various processes which may be substantially represented in non-transitory computer readable media and executed by a computer and/or processor, whether or not such computer and/or processor is explicitly shown.

### DETAILED DESCRIPTION

Specific example embodiments of the inventive concepts are shown by way of example in the drawings and will be described in detail below. It should be understood, however that the example embodiments of the inventive concepts are not limited to the particular forms disclosed herein, but on the contrary, the example embodiments of the inventive concepts are to cover all modifications, equivalents, and/or alternatives falling within the scope of the inventive concepts.

The terms "comprises," "comprising," or any other variations thereof, are intended to cover a non-exclusive inclusion, such that a system, device, non-transitory computer readable medium, and/or method that comprises a list of components and/or operations does not include only those components and/or operations but may include other components and/or operations not expressly listed or inherent to such setup and/or device and/or method. In other words, one or more elements in a system and/or apparatus proceeded by "comprises... a" does not, without more constraints, preclude the existence of other elements and/or additional elements in the system or method, etc.

In the following detailed description of some example embodiments of the inventive concepts, references are made to the accompanying drawings that form a part hereof, and in which are shown by way of illustration specific example embodiments in which the inventive concepts may be practiced. These example embodiments are described in sufficient detail to enable those of ordinary skill in the art to practice the inventive concepts, but it is to be understood that other example embodiments may be utilized and that changes may be made to the example embodiments without departing from the scope of the inventive concepts. The following description is, therefore, not to be taken in a limiting sense.

In some example embodiments, the storage device 105 may refer to any SSD, such as a TLC SSD, a QLC SSD, and/or any higher multi-layered SSD. The SSD may be a portable SSD. The storage device 105 may be an SSD (e.g. a portable SSD) that stores more than one bit per cell. In some example embodiments, the storage device 105 may refer to a Programmable Logic Controller (PLC), but the example embodiments are not limited thereto.

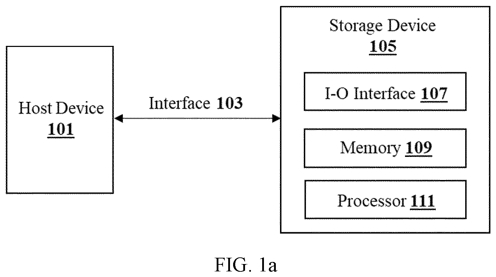

FIG. 1a illustrates an environment for writing data in a storage device in accordance with some example embodiments of the inventive concepts.

In FIG. 1a, the environment includes at least one host device 101, at least one interface 103, and/or at least one storage device 105, etc., but the example embodiments are not limited thereto, and for example, may include a greater or lesser number of constituent components, etc. The host device 101 may be a computer, a laptop, a mobile device, an embedded device, and/or any other computing device and/or electronic device. The host device 101 is connected to the storage device 105 via the interface 103. The interface 103 may be a wired communication interface, but is not limited thereto, and for example, may be a wireless communication interface, etc.

In some example embodiments, the storage device 105 is a NAND based device, but is not limited thereto. The NAND based device may be a portable SSD, but is not limited thereto. The storage device 105 includes an Input/Output (I/O) interface 107 (for example, a communication interface, etc.), at least one memory 109, and/or at least one processor (e.g., processing circuitry, controller, etc.) 111. For example, the storage device 105 may include a memory controller, etc. The I/O interface 107 is configured to receive at least one I/O (also, referred to as an I/O request, etc.) from the host device 101. The I/O (and/or I/O request) may be a write request (also, referred as a data write request), but is not limited thereto. The I/O interface 107 may employ a wired communication protocol/method, but is not limited thereto.

The memory 109 is communicatively coupled to the processor 111 of the storage device 105. The memory 109 also stores controller-executable instructions (e.g., computer readable instructions, computer executable instructions, program code, code, etc.) which may cause the processor 111 to execute the computer readable instructions for, e.g., writing data in the storage device 105, etc. The memory 109 includes, without limitation, memory drives, removable disc drives, etc.

The processor 111 includes at least one data processor for writing data in the storage device 105, but is not limited thereto. The processor 111 may include specialized processing units, such as integrated system (bus) controllers, memory management control units, floating point units, graphics processing units, digital signal processing units, etc. According to some example embodiments, the processor 111, etc., may be implemented as processing circuitry. The processing circuitry may include hardware or hardware circuits including logic circuits; a hardware/software combination such as a processor executing software and/or firmware; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc., but is not limited thereto.

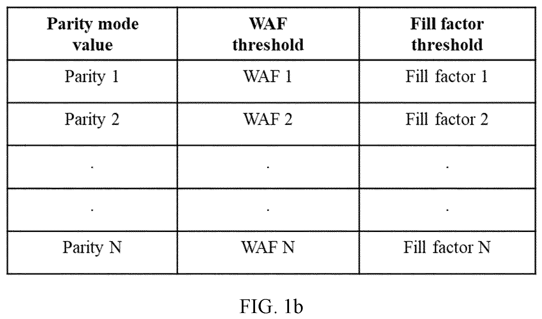

Hereinafter, the operation for writing data in the storage device 105 is explained. For explaining the operation for writing data in the storage device 105 with respect to FIGS. 1b to 1d, the page size is considered as 16K, but the example embodiments are not limited thereto, and the page size may be greater than or less than 16K.

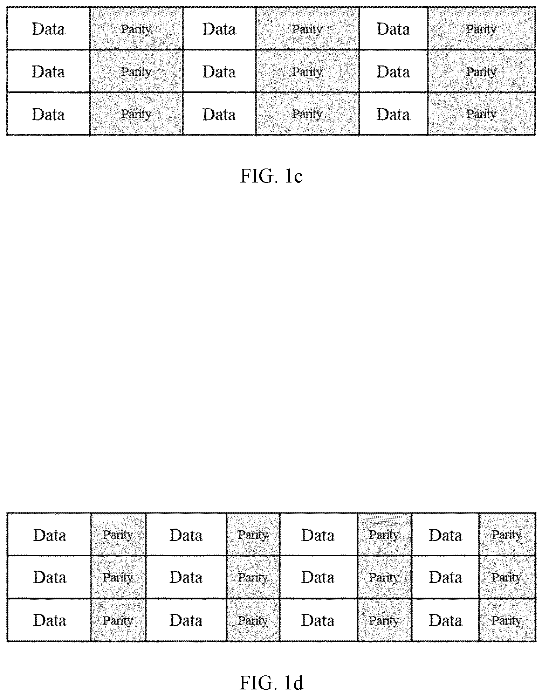

Prior to the operation for writing data in the storage device 105, a table, as shown in FIG. 1b, is stored and/or loaded (e.g., pre-stored and/or pre-loaded) in the memory 109 of the storage device 105. The table may be stored and/or loaded during the manufacturing of the storage device 105, but the example embodiments are not limited thereto, and for example, the table may be loaded after manufacturing of the storage device 105, etc. In detail, the table is a part of software that is written (e.g. flashed) into the storage device 105 during assembly and/or manufacturing of the storage device 105, but is not limited thereto, and for example, the table may be loaded and/or flashed into the storage device 105 (e.g., writing/flashing the firmware and/or ROM of the storage device 105, etc.) at a later time. The table comprises a plurality of parity mode values, a plurality of Write Amplification Factor (WAF) thresholds (also referred to as storage device WAF thresholds) associated with the plurality of parity mode values, and/or a plurality of fill factor thresholds (also referred to as storage device fill factor thresholds) associated with the plurality of parity mode values of the storage device 105, etc., but is not limited thereto. The parity mode values refer to a combination of a number of data units (e.g., the number of units of data per page of memory) and are associated with and/or correspond to a parity size (e.g., the number of parity bits to use for error correction on the stored data), etc., or in other words, the parity mode value includes information on the number of data units per page of memory associated with the parity mode value and the number of parity bits associated with the parity mode value, etc. A particular parity mode (e.g. parity code) may be associated with each parity mode value. Each parity mode may encode data with a particular number of parity bits (e.g. per page). The WAF threshold (e.g., WAF value) refers to a value that represents the amount of data written by the storage device 105 in relation to the amount of data written by the host device 101. The fill factor (e.g., fill factor value) of the storage device 105 refers to the amount of valid data written by the host device 101 in relation to the total data storage capacity of the storage device 105. As used herein, valid data means data that has not been invalidated by the device. Data are deemed invalidated when the corresponding logical ranges have been overwritten, trimmed/deallocated, or otherwise marked stale by the device (e.g., as part of out-of-place updates, garbage collection, or wear-leveling), irrespective of whether stale physical copies persist until block erase. The plurality of parity mode values are arranged in the table in a sequence (e.g. a logical sequence) according to and/or based on a code rate (also referred to as a parity code rate) along with associated WAF threshold and/or fill factor threshold. A code rate of a code (e.g. a parity code) may be the ratio of the number of information bits (e.g. bits before encoding) to the number of encoded bits (e.g. bits after encoding). Each of the plurality of parity mode values are associated with a WAF threshold of a plurality of WAF thresholds and a fill factor threshold of a plurality of fill factor thresholds. The parity mode values may be arranged in order (e.g. increasing order) of code rate. For instance, for increasing parity mode value, the code rate of the associated code may also increase. Accordingly, increasing the parity mode value may decrease the number of parity bits stored (e.g. per page or per data unit). The parity mode values may be arranged in an increasing order of code rate in the table, but are not limited thereto. For example, with reference to the table shown in FIG. 1b, when the parity mode value is Parity 1, the code rate is a lowest code rate (e.g., lowest parity code rate), which means a maximum and/or largest parity size (e.g., the number of parity bits, etc.) is allocated for data units, as shown in FIG. 1c, but the example embodiments are not limited thereto. For example, FIG. 1c shows 3 map (or data) units per physical page, which has a low fill factor. Additionally, when the parity mode value is Parity N, the code rate is a highest code rate (e.g., a highest parity code rate, etc.), which means a minimum and/or lowest parity size (e.g., the number of parity bits, etc.) is allocated for data units, as shown in FIG. 1d, but the example embodiments are not limited thereto. For example, FIG. 1d shows 4 map (or data) units per physical page, which has a high fill factor.

In some example embodiments, the storage device 105 receives a write request from the host device 101 or the write request is an internal garbage collection write operation (e.g. generated by the storage device 105, e.g. periodically). Upon receiving the write request, the storage device 105 determines and/or identifies a WAF value (also referred to as a device WAF value) and/or a fill factor value (also referred to as a device fill factor value) based on the write request and/or storage device condition information (e.g., a performance history of the storage device 105, such as previously stored data and/or previously received write requests), etc. The WAF value and the fill factor value are metrics of the storage device 105 evaluated by the storage device 105 based on the storage device 105 condition (e.g., a status of the storage device 105, etc.). The storage device 105 condition may be based on a current workload of the storage device 105. The current workload may be derived as follows: the storage device 105 logs the number of writes (e.g., write operations) issued by the host device 101 (also referred to as Host Writes) to the storage device 105 as well as the number of writes (e.g., write operations) performed by the storage device 105 (also referred to as NAND Writes, etc.), wherein WAF = NAND Writes/Host Writes (e.g. based on each write operation being a similar or same size). In addition or alternatively, the WAF may be determined by monitoring the amount of data requested by the host to be written and the amount of data stored by the storage device (e.g. WAF = total written by storage/total data requested to be written). In addition or alternatively, the storage device 105 may determine fill factor based on the storage device condition information (e.g. previously stored data). Thereafter, the storage device 105 fetches (e.g. updates) a current parity mode value stored in the storage device 105 based on the calculated current workload. For example, the storage device 105 fetches Parity 1 in the table shown in FIG. 1b, but is not limited thereto. The storage device 105 determines a WAF threshold (also referred to as the storage device WAF threshold) and/or a fill factor threshold (also referred to as the storage device fill factor threshold) of the storage device 105 associated with the current parity mode value. For example, the storage device 105 determines WAF 1 and Fill factor 1 associated with Parity 1 in the table shown in FIG. 1b, but is not limited thereto. The storage device 105 determines whether to change the current parity mode value to a higher parity mode value of a plurality of parity mode values based on the WAF threshold, the WAF value, the fill factor threshold, and/or the fill factor value. In detail, the storage device 105 compares the WAF value with the WAF threshold, and the fill factor value with the fill factor threshold. For example, the storage device 105 compares the WAF value with WAF 1, and the fill factor value with the Fill factor 1, but is not limited thereto. The storage device 105 checks if the WAF threshold is greater than the WAF value and/or checks if the fill factor threshold is greater than the fill factor value. For example, the storage device 105 checks if WAF 1 is greater than the WAF value and/or checks if the Fill factor 1 is greater than the fill factor value, etc.

The storage device 105 writes data in a storage area of the storage device 105 based on results of the determining. In detail, if the WAF threshold is greater than the WAF value (e.g. if the WAF value is less than or equal to the WAF threshold) and/or the fill factor threshold is greater than the fill factor value (e.g. if the fill factor value is less than or equal to the fill factor threshold), the storage device 105 writes data in the storage area of the storage device 105 based on the current parity mode value. For example, if WAF 1 is greater than the WAF value and Fill factor 1 is greater than the fill factor value, the storage device 105 writes data in the storage area of the storage device 105 based on the current parity mode value, which is Parity 1 in this case, but is not limited thereto. For writing in the storage area based on the parity mode value, the storage device 105 modifies a page format of at least one block based on the current parity mode value. For instance, the storage device 105 may write data using a parity code corresponding to the current parity mode value. Accordingly, the storage device 105 may determine the page format based on a parity code (e.g. an amount of parity bits) corresponding to the parity mode value. Thereafter, the storage device 105 allocates at least one block for data storage in the storage device 105 based on the page format and writes the data in the at least one allocated block of the storage device 105. The data may be written using the parity mode corresponding to the parity mode value. Accordingly, the payload data may be encoded using parity code corresponding to the parity mode value to determine data to be written, including parity bits. The page format may define the number and/or location of parity bits within a page. The page format may be defined during an erase operation of the storage device 105, but the example embodiments are not limited thereto. The page format may be maintained in Storage Block Information (SBInfo) of the storage device 105, but is not limited thereto. All of the pages in a block of the storage device 105 may use the same page format, but are not limited thereto.

If the WAF threshold is less than or equal to the WAF value (e.g. if the WAF value is greater than the WAF threshold), and the fill factor threshold is less than or equal to the fill factor value (e.g. the fill factor value is greater than the fill factor threshold), the storage device 105 increases the parity mode value. For instance, the storage device 105 may change the current parity mode value to a next parity mode value (e.g., a higher parity mode value, etc.) of the plurality of parity mode values in the table stored in the storage device 105, but the example embodiments are not limited thereto. In this case, the parity mode value may be increased by one. For example, if the WAF 1 is less than or equal to the WAF value and the Fill factor 1 is less than or equal to the device fill factor value, the storage device 105 changes the current parity mode value, which is Parity 1, to Parity 2, etc. The storage device 105 determines a WAF threshold and a fill factor threshold of the storage device 105 associated with the current parity mode value (e.g. the new current parity mode value, the updated current parity mode value, etc.), which is Parity 2. For example, the storage device 105 determines that the WAF threshold and the fill factor threshold associated with parity mode WAF 2 is WAF 2 and Fill factor 2, respectively. The storage device 105 then changes the WAF threshold to the next WAF threshold (e.g., WAF 2), and changes the fill factor threshold to the next fill factor threshold (e.g., Fill factor 2), etc. For example, the storage device 105 changes the WAF threshold from WAF 1 to WAF 2 and the fill factor threshold from Fill factor 1 to Fill factor 2, etc. That is, the storage device 105 updates the WAF threshold and fill factor threshold to the WAF threshold and fill factor of the new current parity mode value. The storage device 105 compares the WAF value with the WAF threshold, and compares the fill factor value with the fill factor threshold. For example, the storage device 105 compares the WAF value with WAF 2, and compares the fill factor value with the Fill factor 2. The storage device 105 checks if the WAF threshold is greater than the WAF value and the fill factor threshold is greater than the fill factor value. For example, the storage device 105 checks if the WAF 2 is greater than the WAF value and checks if the Fill factor 2 is greater than the fill factor value, etc.

If the WAF threshold is greater than the WAF value and/or the fill factor threshold is greater than the fill factor value, the storage device 105 writes data in the storage area of the storage device 105 based on the current parity mode value. For example, if WAF 2 is greater than the WAF value and Fill factor 2 is greater than the fill factor value, the storage device 105 writes data in the storage area of the storage device 105 based on the current parity mode value, which is Parity 2 in this case. For writing in the storage area based on the current parity mode value, the storage device 105 may modify a page format of at least one block based on the current parity mode value. Thereafter, the storage device 105 allocates at least one block for data storage in the storage device 105 based on the page format and writes the data in the at least one allocated block of the storage device 105.

If the WAF threshold is less than or equal to the WAF value and the fill factor threshold is less than or equal to the fill factor value, the storage device 105 changes the parity mode value to a next parity mode value of the plurality of parity mode values in the table stored in the storage device 105, but the example embodiments are not limited thereto. For example, if WAF 2 is less than or equal to the WAF value and if the Fill factor 2 is less than or equal to the fill factor value, the storage device 105 changes the current parity mode value, which is Parity 2, to Parity 3, but is not limited thereto. The storage device 105 repeats the above-mentioned operations of changing the current parity mode value with a next parity mode value, which then becomes the current parity mode, in the table as shown in FIG. 1b, determining the WAF threshold and the fill factor threshold of the storage device associated with the current parity mode value, changing the WAF threshold with the WAF threshold associated with the current parity mode value and the fill factor threshold with the fill factor threshold associated with the current parity mode value, comparing the WAF threshold with the WAF value, and the fill factor threshold with the fill factor value, until the WAF threshold is greater than the WAF value and the fill factor threshold is greater than the fill factor value. The approach of dynamically selecting the WAF threshold and fill factor threshold based on parity mode value in one or more example embodiments of the inventive concepts reduces and/or solves the data retention problem of the portable SSD. That is by storing data with higher parity size, the tolerance for data retention is greater and the ability to correct the data is higher. Further, the portable SSD implemented with the approach of one or more example embodiments of the inventive concepts is less prone to uncorrectable errors due to issues related to inactivity of the portable SSD, such as cell volt leakage or/and temperature variations in the portable SSD, etc.

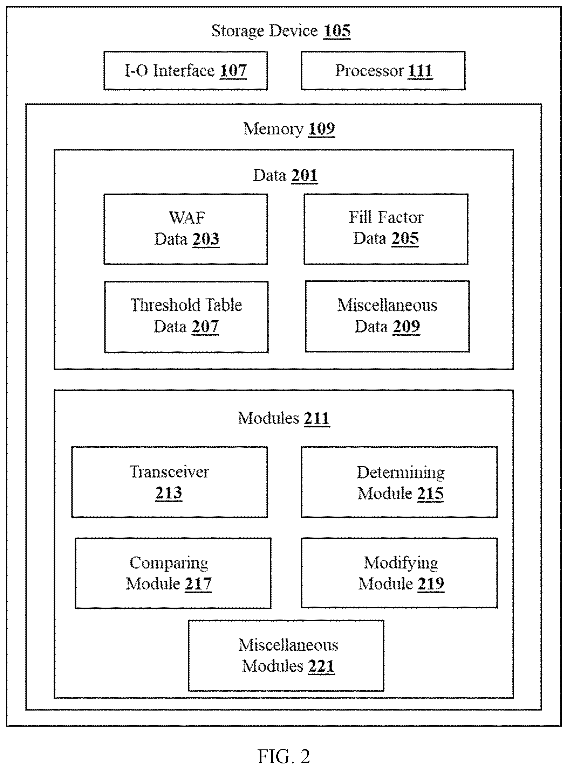

FIG. 2 shows a detailed block diagram of a storage device in accordance with some example embodiments of the inventive concepts.

The storage device 105, in addition to the I/O interface 107 and the processor 111 described above, may include data 201 and/or one or more modules (and/or circuits, devices, etc.) 211, but the example embodiments are not limited thereto. In some example embodiments, the data 201 is stored within the memory 109 (for example within a memory array). The data 201 may include, for example, WAF data 203, fill factor data 205, threshold table data 207, and/or miscellaneous data 209, etc., but is not limited thereto.

The WAF data 203 includes and/or stores a device WAF value of the storage device 105. The WAF (e.g., WAF value) refers to a value that represents the amount of data written to and/or stored by the storage device 105 in relation to the amount of data written by the host device 101.

The fill factor data 205 includes and/or stores a device fill factor value of the storage device 105. The fill factor (e.g., fill factor value) of the storage device 105 refers to the amount of valid data written by the host device 101 in relation to the total storage capacity of the storage device 105.

The threshold table data 207 includes and/or stores a table comprising a plurality of parity mode values and associated and/or corresponding WAF threshold and/or fill factor threshold of the storage device 105, as shown in FIG. 1b. The table, as shown in FIG. 1b, is stored and/or loaded (e.g., pre-stored and/or pre-loaded) in the threshold table data 207 of the memory 109 during manufacturing of the storage device 105, but the example embodiments are not limited thereto. The plurality of parity mode values may be arranged in a logical sequence according to and/or based on a parity code rate (also referred to as a code rate) along with associated WAF threshold and fill factor threshold in the table, but is not limited thereto. The parity mode value may be arranged in an increasing order of parity code rates in the table, but is not limited thereto. The parity mode value includes information regarding a number of data units per physical page and a number of parity bits (e.g., the parity size) corresponding to the parity mode value.

The miscellaneous data 209 may include data, including at least one of meta data and/or temporary files, etc., generated by one or more modules 211 (e.g., circuitry, devices, etc.) for performing the various functions of the storage device 105.

In some example embodiments, the data 201 in the memory 109 are processed by the one or more modules 211 present within the memory 109 of the storage device 105, but the example embodiments are not limited thereto, and for example, the operations associated with the one or more modules 211 may be performed by the processor 111, etc. In some example embodiments, the one or more modules 211 are implemented as dedicated hardware units (for example, circuits or processing circuitry). As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, Application-Specific Integrated Circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a Dynamic Random-Access Memory (DRAM) device, storing a program of computer readable instructions, and a processor (e.g., CPU) configured to execute the program of computer readable instructions to implement the functionality and/or methods performed by some or all of any devices, systems, modules, units, controllers, circuits, architectures, and/or portions thereof according to any of the example embodiments, and/or any portions thereof.

In some example embodiments, the one or more modules 211 are communicatively coupled to the processor 111 for performing one or more functions of the storage device 105, but the example embodiments are not limited thereto. The one or more modules 211, when configured with the functionality defined in one or more example embodiments of the inventive concepts, result in special purpose hardware, a special purpose storage device, and/or a special purpose computing device. In some example embodiments, the processor 111 (also, referred as controller) includes the one or more modules 211.

In some example embodiments, the one or more modules 211 include, but are not limited to, a transceiver 213, a determining module 215, a comparing module 217 and/or a modifying module 219, etc., but for example, one or more of the modules may be combined, omitted, etc. The one or more modules 211 may further include miscellaneous modules 221 to perform various miscellaneous functionalities of the storage device 105. According to some example embodiments, one or more of the processor 111, transceiver 213, determining module 215, comparing module 217 and/or the modifying module 219, etc., may be implemented as processing circuitry.

In some example embodiments, the transceiver 213 is configured to receive a write request from the host device 101 and/or receive an internal garbage collection write request.

In some example embodiments, the determining module 215 is configured to determine a WAF value and/or a fill factor value associated with the storage device 105 upon receiving the write request (e.g. from the host device 101). The WAF value and the fill factor value are metrics of the storage device 105 evaluated by the storage device 105 based on storage device 105 condition(s), etc. The WAF (e.g., WAF value) refers to a value that represents the amount of data written by the storage device 105 in comparison to the amount of data written by the host device 101. The fill factor (e.g., fill factor value) of the storage device 105 refers to the amount of valid data written by the host device 101 in comparison to the total storage capacity of the storage device 105. The storage device 105 condition may be based on a current workload of the storage device 105. The current workload is derived as follows: the storage device 105 logs the number of writes (e.g., write operations) issued by the host device 101 (also referred to as a Host Writes) to the storage device 105 as well as the number of writes performed by the storage device 105 (also to referred to as NAND Writes, etc.), wherein WAF = NAND Writes/Host Writes. The determining module 215 is configured to fetch and/or identify a current parity mode value stored in the storage device 105. The current parity mode value may be stored in the miscellaneous data 209 of the memory 109, but is not limited thereto. The determining module 215 is configured to determine and/or identify a WAF threshold and/or a fill factor threshold of the storage device 105 associated with the current parity mode value. If the WAF threshold is less than or equal to the WAF value and the fill factor threshold is less than or equal to the fill factor value, the determining module 215 is configured to change the current parity mode value to a next parity mode value, which then becomes the current parity mode, of the plurality of parity mode values in the table stored in the storage device 105 (also, this operation is referred to as operation 1), but the example embodiments are not limited thereto. The table, as shown in FIG. 1b, may be pre-stored or pre-loaded in the memory 109 of the storage device 105 during manufacturing of the storage device 105, but the example embodiments are not limited thereto. The parity mode value may be arranged in an increasing order of code rate (e.g., parity code rate, etc.) in the table, but is not limited thereto. The plurality of parity mode values are arranged in a logical sequence according to a parity code rate (e.g., arranged in sequential order, etc.) along with associated WAF threshold and fill factor threshold in the table, but the example embodiments are not limited thereto. The parity mode value includes information regarding a number of data units per physical page and a number of parity bits (e.g., parity size) corresponding to the parity mode value. The determining module 215 is configured to determine whether to change the current parity mode value to a higher (or next) parity mode value of the plurality of parity mode values based on the WAF threshold, the WAF value, the fill factor threshold, and the fill factor value. In detail, the determining module 215 is configured to determine a next WAF threshold and/or a next fill factor threshold of the storage device 105 associated with the current parity mode value from the table, as shown in FIG. 1b (also, this operation is referred to as operation 2), but the example embodiments are not limited thereto. The determining module 215 is configured to change the WAF threshold to the next WAF threshold and the fill factor threshold to the next fill factor threshold (also, this operation is referred to as operation 3), etc. The operation 1, the operation 2, and/or the operation 3 are repeated until the WAF threshold is greater than the WAF value and the fill factor threshold is greater than the fill factor value, but the example embodiments are not limited thereto.

In some example embodiments, the comparing module 217 is configured to compare the WAF value with the WAF threshold, and the fill factor value with the fill factor threshold.

In some example embodiments, the modifying module 219 is configured to write data in the storage area of the storage device 105 based on the current parity mode value if the WAF threshold is greater than the WAF value and/or the fill factor threshold is greater than the fill factor value. In detail, the modifying module 219 is configured to modify a page format of at least one block of the storage device 105 based on the current parity mode value. The modifying module 219 is configured to allocate at least one block for data storage in the storage device 105 based on the page format. The modifying module 219 is configured to write the data in the at least one allocated block of the storage device 105.

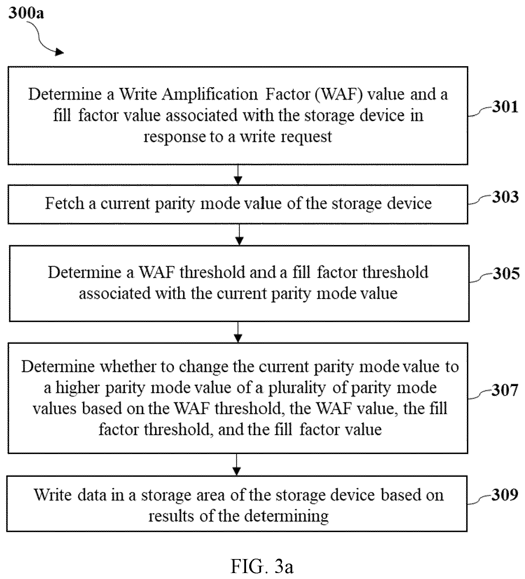

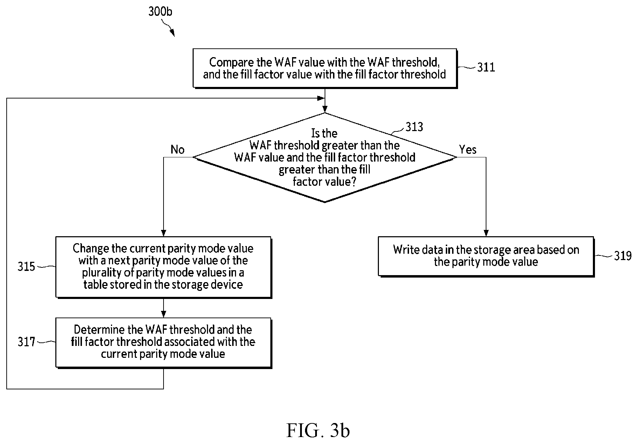

FIGS. 3a and 3b illustrate flowcharts showing a method for writing data in a storage device in accordance with some example embodiments of the inventive concepts.

As illustrated in FIGS. 3a and 3b, the methods 300a and 300b include operations for writing data in the storage device. The methods 300a and 300b may be described in the general context of special purpose computer executable instructions being executed by at least one processor and/or processing circuitry, etc. Generally, computer executable instructions can include routines, programs, objects, components, data structures, procedures, units, and/or functions, which perform particular functions and/or implement particular abstract data types when executed by at least one processor and/or processing circuitry included in a computing device, etc.

The order in which the operations of methods 300a and 300b are described is not intended to be construed as limitations, and any number of the described method operations may be combined and/or rearranged in any order to implement the method. Additionally, individual operations may be deleted from the methods without departing from the scope of the example embodiments of the inventive concepts described herein. Furthermore, the method may be implemented in hardware and/or a combination of hardware executing software and/or firmware, etc.

At operation 301, the determining module 215 (e.g., the processing circuitry) of the storage device 105 determines a WAF value and/or a fill factor value associated with the storage device 105 upon receiving a write request. The write request is received by the transceiver 213 of the storage device 105 from the host device 101 and/or is an internal garbage collection write request.

At operation 303, the determining module 215 of the storage device 105 fetches a parity mode value stored in the storage device 105, or in other words, the current parity mode value of the storage device 105.

At operation 305, the determining module 215 of the storage device 105 determines a WAF threshold and a fill factor threshold of the storage device 105 associated with the parity mode value (e.g., the current parity mode value, etc.).

At operation 307, the determining module 215 of the storage device 105 determines whether to change the current parity mode value to a higher (or next) parity mode value of a plurality of parity mode values based on the WAF threshold, the WAF value, the fill factor threshold, and the fill factor value.

At operation 309, the modifying module 219 (e.g., processing circuitry) of the storage device 105 writes data in a storage area of the storage device based on results of the determining. The writing may comprise writing data in the storage area using a parity mode corresponding to the parity mode value. The parity mode may define an amount of parity bits to be written (e.g. per page). The writing may comprise encoding the data using a parity code corresponding to the parity mode value and writing the encoded data to the storage area. The encoded data may comprise payload data and parity bits.

The operations related to determining whether to change the current parity mode value to the higher (or next) parity mode value of a plurality of parity mode values based on the WAF threshold, the WAF value, the fill factor threshold, and the fill factor value are described below.

At operation 311, the comparing module 217 of the storage device 105 compares the WAF value with the WAF threshold, and the fill factor value with the fill factor threshold.

At operation 313, the comparing module 217 of the storage device 105 checks if the WAF threshold is greater than the WAF value, and the fill factor threshold is greater than the fill factor value.

If the WAF threshold is less than or equal to the WAF value and/or the fill factor threshold is less than or equal to the fill factor value (e.g. if the WAF threshold is not greater than the WAF value and/or if the fill factor threshold is not greater than the fill factor value), the operations 313 to 317 are performed until the WAF threshold is greater than the WAF value and the fill factor threshold is greater than the fill factor value.

At operation 315, the determining module 215 of the storage device 105 changes the current parity mode value to a next parity mode value (e.g., a higher parity mode value, etc.) of a plurality of parity mode values in a table stored in the storage device 105. In other words, the next parity mode value becomes the current parity mode value. The parity mode values are arranged in an increasing order of parity code rates in the table, as shown in FIG. 1b, but the example embodiments are not limited thereto. The plurality of parity mode values are arranged in a logical sequence according to a parity code rate along with an associated WAF threshold and a fill factor threshold in the table, but are not limited thereto. The parity mode value refers to a combination of number of data units (e.g., a number of map units per page, etc.) and a corresponding parity size (e.g., corresponding parity bit size or parity bits, etc.).

At operation 317, the determining module 215 of the storage device 105 determines the WAF threshold and the fill factor threshold of the storage device 105 associated with the current parity mode value.

At operation 319, if the WAF threshold is greater than the WAF value and the fill factor threshold is greater than the fill factor value, the modifying module 219 of the storage device 105 writes data in the storage area of the storage device 105 based on the parity mode value (e.g., the current parity mode).

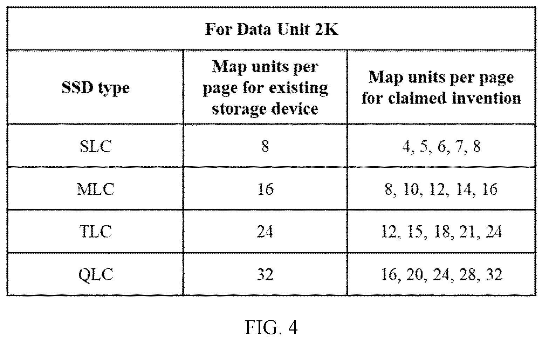

FIG. 4 illustrates comparative examples of parity mode values for a conventional storage device and parity mode values for at least one example embodiment of the inventive concepts.

In FIG. 4, the number of map units (e.g. data units) per page for a conventional storage device is static (e.g., cannot be changed). A map unit (otherwise known as a data unit) may be an addressable unit (e.g. a minimum addressable unit) of storage (e.g. a predefined number of bits and/or memory cells). For example, for SLC SSD, the number of map units per page is 8. For MLC SSD, the number of map units per page is 16. For TLC SSD, the number of map units per page is 24. For QLC SSD, the number of map units per page is 32. However, the number of map units per page for the storage device 105 of at least one example embodiment is dynamic, and the number of map units per page changes based on the parity mode values as explained above with reference to FIGS. 1a to 1d, but is not limited thereto. For example, for SLC SSD, the possible number of map units per page is one of 4, 5, 6, 7, and 8, etc. For MLC SSD, the possible number of map units per page is one of 8, 10, 12, 14, and 16, etc. For TLC SSD, the possible number of map units per page is one of 12, 15, 18, 21, and 24, etc. For QLC SSD, the possible number of map units per page is one of 16, 20, 24, 28, and 32, etc. In the above examples, the page size is as assumed to be 16KB and the map unit (e.g. data unit) size is assumed to be 2KB, but the example embodiments are not limited thereto.

Some example uses cases of some example embodiments of the inventive concepts are given below:

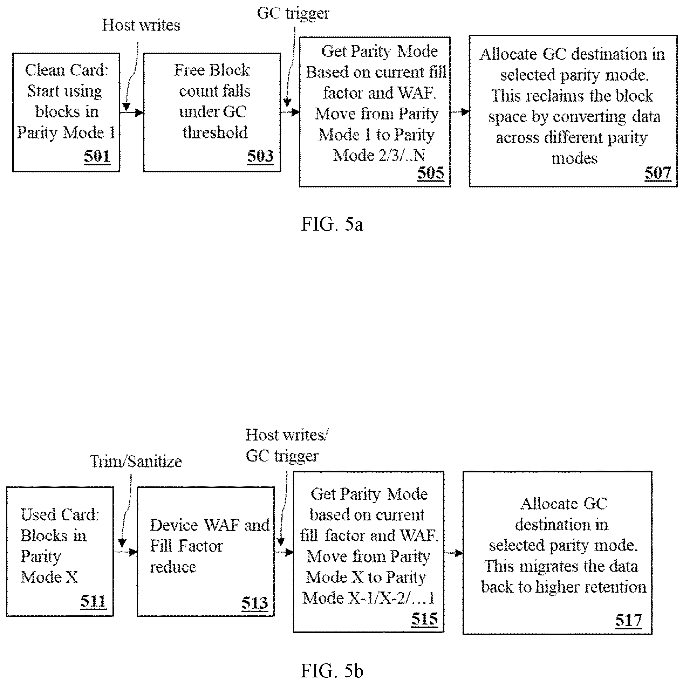

Consider scenario 1 (depicted in FIG. 5a) in which blocks of the storage device 105 are clean, e.g., no data is stored in the storage device 105 and the parity mode value is Parity 1 (refer to operation 501 in FIG. 5a). In this situation, when the storage device 105 receives a write request from the host device 101, the storage device 105 modifies a page format of at least one block based on the parity mode value, which could be, say Parity 1, allocates at least one block for data storage, and writes data in the at least one block in the storage device 105. At this stage, consider that the free block count falls below a garbage collection (GC) threshold (refer to operation 503 in FIG. 5a), or in other words, determine whether a trigger has been reached. When the trigger has been reached, e.g., the free block count has fallen below the GC threshold causing an internal GC write request to be triggered and/or causing an internal GC write operation to be performed, etc., the storage device 105 determines the (current) WAF value and the (current) fill factor value and changes the current parity mode value, e.g., Parity 1, to a next parity mode value in the table (as shown in FIG. 1b) until the WAF threshold is greater than the WAF value and the fill factor threshold is greater than the fill factor value (refer to operation 505 in FIG. 5a), but the example embodiments are not limited thereto. The storage device 105 modifies the page format of at least one block based on the parity mode value, which could be one of Parity 4..., Parity N, allocates at least one block for data storage, and writes data in the at least one allocated block in the storage device 105 (refer to operation 507 in FIG. 5a), etc.

Consider scenario 2 (depicted in FIG. 5b) in which one or more blocks of the storage device 105 are used, e.g., the storage device 105 has data stored in its blocks and the parity mode value is Parity 5 (refer to operation 511 in FIG. 5b), but the example embodiments are not limited thereto. Suppose the WAF value and the fill factor value are much less and/or below the WAF threshold and the fill factor threshold of the storage device 105 (refer to operation 513 in FIG. 5b). When the storage device 105 receives a write request from the host device 101 and/or an internal garbage collection write request and/or trigger, etc., the storage device 105 changes (e.g. reduces) the current parity mode value, e.g., Parity 5, to a next (e.g. smaller/lower) parity mode value in the table (as shown in FIG. 1b) until the WAF threshold is greater than the lower WAF value and the fill factor threshold is greater than the lower fill factor value (refer to operation 515 in FIG. 5b), but the example embodiments are not limited thereto. In this case, the parity mode value may change from Parity 5 to Parity 1. The storage device 105 modifies the page format of at least one block based on the parity mode value, e.g., Parity 1, allocates at least one block for data storage, and writes data in the at least one allocated block in the storage device 105 (refer to operation 517 in FIG. 5b), etc.

As an example, a lower WAF threshold and/or a lower fill factor threshold may be set. These may be lower than the WAF threshold and the fill factor threshold respectively. These might define lower limits for the respective values. As an example, the lower WAF threshold may be equal to the WAF threshold minus a WAF offset. Alternatively, or in addition, the lower WAF threshold for the given parity mode may be stored in the table. As an example, the lower fill factor threshold may be equal to the fill factor threshold minus a fill factor offset. Alternatively, or in addition, the lower fill factor threshold for the given parity mode may be stored in the table. In response to the WAF value being less than or equal to the lower WAF threshold and/or and the fill factor value being less than or equal to the lower fill factor threshold, the parity mode value may be reduced (e.g. reduced by one). This may continue until the WAF value is greater than the lower WAF threshold and the fill factor value is greater than the fill factor threshold.

For instance, each parity mode value may be allocated a range (e.g. between lower and upper thresholds) of WAF values and a range (e.g. between lower and upper thresholds) of fill factor values. In response to the WAF value falling outside of the range of WAF values and/or the fill factor value falling outside the range of fill factor values, the parity value may be changed. The parity value may be increased in response to the WAF value exceeding the range of WAF values and/or the fill factor exceeding the range of fill factor values. The parity value may be decreased in response to the WAF value falling below the range of WAF values and/or the fill factor falling below the range of fill factor values. More generally, the storage device 105 may determine the lowest parity value for which the range of WAF values encompasses the WAF value and for which the range of fill factor values encompasses the fill factor value. In response to the WAF value falling within the range of WAF values and the fill factor value falling within the range of fill factor values, data may be stored in the storage device 105 based on the current parity mode value.

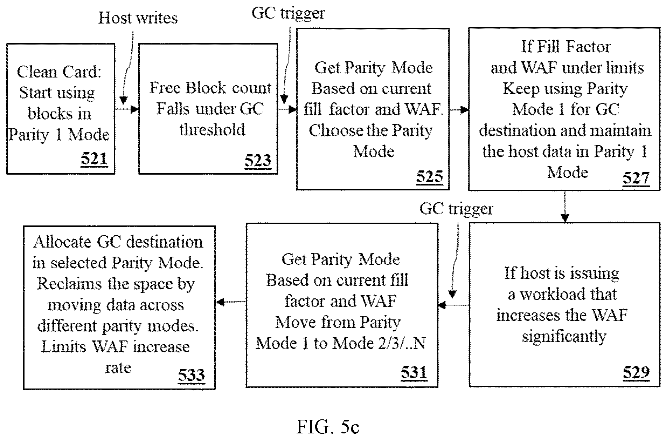

Consider scenario 3 in which one or more blocks of the storage device 105 are clean, e.g., no data is stored in the storage device 105 and the current parity mode value is Parity 1 (refer to operation 521 in FIG. 5c), etc. In this situation, when the storage device 105 receives a write request from the host device 101, the storage device 105 modifies a page format of at least one block based on the parity mode value, which could be, say Parity 1, allocates at least one block for data storage, and writes data in the at least one allocated block in the storage device 105, but the example embodiments are not limited thereto. At this stage, consider that the free block count falls below the garbage collection threshold (refer to operation 523 in FIG. 5c). When there is an internal Garbage Collection (GC) write request and/or trigger, the storage device 105 determines the (current) WAF value and the (current) fill factor value and may maintain the parity mode value as Parity 1 based on whether the WAF is greater than the (current) WAF value and the fill factor threshold is greater than the (current) fill factor value (refer to operations 525 and 527 in FIG. 5c), but the example embodiments are not limited thereto. The storage device 105 modifies the page format of the at least one block based on the parity mode value, which is Parity 1, allocates at least one block for data storage, and writes data in the at least one allocated block in the storage device 105 (refer to operation 527 in FIG. 5c). Further, if the storage device 105 receives a write request (and/or a workload) from the host device 101 that significantly increases the WAF (refer to operation 529 in FIG. 5c) (e.g. increases the WAF by more than a threshold amount and/or more than a threshold rate of change), the storage device 105 determines the (current) WAF value and the (current) fill factor value, and changes the parity mode value from Parity 1 to a next parity mode value based on whether the WAF threshold is greater than the (current) WAF value and the fill factor threshold is greater than the (current) fill factor value (refer to operation 531 in FIG. 5c), but the example embodiments are not limited thereto. The storage device 105 modifies a page format of at least one block based on the parity mode value, allocates at least one block for data storage, and writes data in the at least one allocated block in the storage device 105 (refer to operation 533 in FIG. 5c).

Some technical advantages of one or more example embodiments of the inventive concepts are given below.

At least one example embodiment of the inventive concepts may improve and/or solve the data retention problem of the portable SSD by dynamically selecting WAF threshold and/or fill factor threshold based on parity mode values, etc.

The SSD implemented with the method of at least one example embodiment of the inventive concepts is less prone to uncorrectable errors due to cell volt leakage or/and temperature variations in the SSD, etc.

The described operations may be implemented as a method, system, and/or article of manufacture using programming and/or engineering techniques to be executed on hardware or a combination of hardware and software and/or firmware, etc. The described operations may be implemented as code (e.g., computer readable instructions, etc.) maintained in a non-transitory computer readable medium, where a processor may read and execute the code from the non-transitory computer readable medium. The processor is at least one of a microprocessor or a processor capable of processing and/or executing the code. A non-transitory computer readable medium may include media such as magnetic storage medium (for example, hard disk drives, floppy disks, tape, etc.), optical storage (CD-ROMs, DVDs, Blu-rays, optical disks, etc.), volatile and/or non-volatile memory devices (for example, EEPROMs, ROMs, PROMs, RAMs, DRAMs, SRAMs, Flash Memory, firmware, programmable logic, etc.), etc. Further, non-transitory computer-readable media include all computer-readable media except for transitory signals. The code implementing the described operations may further be implemented in hardware logic (for example, an integrated circuit chip, Programmable Gate Array (PGA), ASIC, etc.).

The terms "including", "comprising", "having" and variations thereof mean "including but not limited to", unless expressly specified otherwise.

The enumerated listing of items does not imply that any or all of the items are mutually exclusive, unless expressly specified otherwise.

The terms "a", "an" and "the" mean "one or more", unless expressly specified otherwise.

A description of some example embodiments with several components in communication with each other does not imply that all such components are desired and/or required. On the contrary, a variety of optional components are described to illustrate the wide variety of possible example embodiments of the inventive concepts.

When a single device or article is described herein, it will be readily apparent that more than one device/article (whether or not they cooperate) may be used in place of a single device/article. Similarly, where more than one device or article is described herein (whether or not they cooperate), it will be readily apparent that a single device/article may be used in place of the more than one device or article or a different number of devices/articles may be used instead of the shown number of devices or programs. The functionality and/or the features of a device may be alternatively embodied by one or more other devices which are not explicitly described as having such functionality/features. Thus, other example embodiments of the inventive concepts need not include the device itself.

The illustrated operations of FIGS. 3a and 3b show certain events occurring in a certain order. In alternative example embodiments, certain operations may be performed in a different order, modified, and/or removed. Moreover, operations may be added to the above-described logic and still conform to one or more of the described example embodiments. Further, operations described herein may occur sequentially and/or certain operations may be processed in parallel. Yet further, operations may be performed by a single processing unit (e.g., processing circuitry, a processor, a processor core, etc.) and/or by distributed processing units (e.g., processing circuitry, a plurality of processors, a plurality of processor cores, etc.).

While certain embodiments describe performing certain actions in response to a value being greater than a threshold, and certain other actions in response to the value being less than or equal to a threshold, it will be appreciated that the thresholds and conditions may be mathematically adjusted without affecting the technical effect of the embodiment. For instance, the threshold and conditions may be defined slightly differently to perform certain actions in response to a value being greater than or equal to the threshold, and certain other actions in response to the value being less than the threshold.

Finally, the language used in the specification has been principally selected for readability and instructional purposes, and it may not have been selected to delineate or circumscribe the example embodiments of the inventive concepts. It is therefore intended that the scope of the example embodiments of the inventive concepts be limited not by this detailed description, but rather by any claims that issue on an application based here on. Accordingly, the disclosure of some example embodiments of the inventive concepts is intended to be illustrative, but not limiting, of the scope of the inventive concepts, which are set forth in the following claims.

While various aspects and example embodiments have been disclosed herein, other aspects and example embodiments will be apparent to those of ordinary skill in the art. The various aspects and example embodiments disclosed herein are for purposes of illustration and are not intended to be limiting, with the true scope being indicated by the following claims.

## Claims

1. A method for writing data in a storage device performed by the storage device, comprising:
determining (301) a Write Amplification Factor, WAF, value and a fill factor value associated with the storage device in response to a write request;
fetching (303) a current parity mode value of the storage device;
determining (305) a WAF threshold and a fill factor threshold associated with the current parity mode value;
determining (307) whether to change the current parity mode value to a higher parity mode value of a plurality of parity mode values based on the WAF threshold, the WAF value, the fill factor threshold, and the fill factor value; and
writing (309) data in a storage area of the storage device based on results of the determining.

2. The method as claimed in claim 1, wherein
the plurality of parity mode values are arranged in a logical sequence according to their respective parity code rates; and
each of the plurality of parity mode values is associated with a corresponding WAF threshold of a plurality of WAF thresholds and a corresponding fill factor threshold of a plurality of fill factor thresholds.

3. The method as claimed in claim 2, wherein the plurality of parity mode values is arranged in an increasing order of parity code rates in a table.

4. The method as claimed in any preceding claim, wherein the current parity mode value includes information regarding a number of data units per physical page and a number of parity bits corresponding to the parity mode value.

5. The method as claimed in any preceding claim, wherein the writing (309) data in the storage area based on the current parity mode value further comprises:
modifying a page format of at least one block based on the current parity mode value;
allocating at least one block of the storage device for data storage based on the page format; and
writing the data in the at least one allocated block.

6. The method as claimed in any preceding claim, wherein the determining (307) whether to change the current parity mode value to the higher parity mode value further comprises:
determining whether the WAF value is greater than the WAF threshold;
determining whether the fill factor value is greater than the fill factor threshold; and
in response to the WAF value being greater than the WAF threshold and/or the fill factor value being greater than the fill factor threshold:
changing the current parity mode value to a next parity mode value of the plurality of parity mode values; and
changing the WAF threshold and the fill factor threshold to a new WAF threshold and a new fill factor threshold associated with the current parity mode value.

7. The method as claimed in any preceding claim, wherein:
the WAF value is a value indicating an amount of data written by the storage device in comparison to an amount of data written by a host device; and
the fill factor value is a value indicating an amount of valid data stored in the storage device in relation to a total storage capacity of the storage device.

8. A storage device, comprising:
processing circuitry (111); and
a memory (109) communicatively coupled to the processing circuitry (111), wherein the memory (109) is configured to store computer executable instructions, which when executed, cause the processing circuitry (111) to:
determine (301) a Write Amplification Factor, WAF, value and a fill factor value associated with the storage device in response to a write request;
fetch (303) a current parity mode value of the storage device;
determine (305) a WAF threshold and a fill factor threshold associated with the current parity mode value;
determine (307) whether to change the current parity mode value to a higher parity mode value of a plurality of parity mode values based on the WAF threshold, the WAF value, the fill factor threshold, and the fill factor value; and
write (309) data in a storage area of the storage device based on results of the determining.

9. The storage device as claimed in claim 8, wherein
the plurality of parity mode values are arranged in a logical sequence according to their respective parity code rates; and
each of the plurality of parity mode values are associated with a corresponding WAF threshold of a plurality of WAF thresholds and a corresponding fill factor threshold of a plurality of fill factor thresholds.

10. The storage device as claimed in claim 9, wherein the plurality of parity mode values is arranged in an increasing order of parity code rates in a table.

11. The storage device as claimed in any of claims 8-10, wherein the current parity mode value includes information regarding a number of data units per physical page and a number of parity bits corresponding to the parity mode value.

12. The storage device as claimed in any of claims 8-11, wherein the processing circuitry (111) is further caused to:
modify a page format of at least one block based on the current parity mode value;
allocate at least one block of the storage device for data storage based on the page format; and
write the data in the at least one allocated block.

13. The storage device as claimed in any of claims 8-12, wherein the processing circuitry (111) is further caused to determine whether to change the current parity mode value to the higher parity mode value by:
determining whether the WAF value is greater than the WAF threshold;
determining whether the fill factor value is greater than the fill factor threshold; and
in response to WAF value being greater than the WAF threshold and the fill factor value being greater than the fill factor threshold:
changing the current parity mode value to a next parity mode value of the plurality of parity mode values, and
changing the WAF threshold and the fill factor threshold to a new WAF threshold and a new fill factor threshold associated with the current parity mode value.

14. The storage device as claimed in any of claims 8-13, wherein:
the WAF value is a value indicating an amount of data written by the storage device in comparison to an amount of data written by a host device; and
the fill factor value is a value indicating an amount of valid data stored in the storage device in relation to a total storage capacity of the storage device.

15. The storage device of any of claims 8-14, wherein the processing circuitry (111) is further caused to:
receive the write request; and
determine whether a trigger has been reached based on the write request,
wherein the determining the WAF value and the fill factor value associated with the storage device is in response to the trigger being reached.

## Patentansprüche

1. Verfahren zum Schreiben von Daten in eine Speichervorrichtung, das durch die Speichervorrichtung durchgeführt wird, umfassend:
Bestimmen (301) eines Werts eines Schreibverstärkungsfaktors, WAF, und eines Füllfaktor-Werts, die mit der Speichervorrichtung assoziiert sind, als Antwort auf eine Schreibanforderung;
Abrufen (303) eines aktuellen Paritätsmodus-Werts der Speichervorrichtung;
Bestimmen (305) eines WAF-Schwellenwerts und eines Füllfaktor-Schwellenwerts, die mit dem aktuellen Paritätsmodus-Wert assoziiert sind;
Bestimmen (307), ob der aktuelle Paritätsmodus-Wert auf einen höheren Paritätsmodus-Wert aus einer Vielzahl von Paritätsmodus-Werten geändert werden soll, und zwar auf der Grundlage des WAF-Schwellenwerts, des WAF-Werts, des Füllfaktor-Schwellenwerts und des Füllfaktor-Werts; und
Schreiben (309) von Daten in einen Speicherbereich der Speichervorrichtung auf der Grundlage von Ergebnissen des Bestimmens.

2. Verfahren nach Anspruch 1, wobei
die Vielzahl von Paritätsmodus-Werten in einer logischen Folge gemäß ihren jeweiligen Paritätscode-Raten angeordnet sind; und
jeder der Vielzahl von Paritätsmodus-Werten mit einem entsprechenden WAF-Schwellenwert aus einer Vielzahl von WAF-Schwellenwerten und einem entsprechenden Füllfaktor-Schwellenwert aus einer Vielzahl von Füllfaktor-Schwellenwerten assoziiert ist.

3. Verfahren nach Anspruch 2, wobei die Vielzahl von Paritätsmodus-Werten in einer aufsteigenden Reihenfolge von Paritätscode-Raten in einer Tabelle angeordnet ist.

4. Verfahren nach einem vorstehenden Anspruch, wobei der aktuelle Paritätsmodus-Wert Informationen bezüglich einer Anzahl von Dateneinheiten pro physischer Seite und einer dem Paritätsmodus-Wert entsprechenden Anzahl von Paritätsbits einschließt.

5. Verfahren nach einem vorstehenden Anspruch, wobei das Schreiben (309) von Daten in den Speicherbereich auf der Grundlage des aktuellen Paritätsmodus-Werts ferner umfasst:
Ändern eines Seitenformats mindestens eines Blocks auf der Grundlage des aktuellen Paritätsmodus-Werts;
Zuteilen von mindestens einem Block der Speichervorrichtung für die Datenspeicherung auf der Grundlage des Seitenformats; und
Schreiben der Daten in den mindestens einen zugewiesenen Block.

6. Verfahren nach einem vorstehenden Anspruch, wobei das Bestimmen (307), ob der aktuelle Paritätsmodus-Wert auf den höheren Paritätsmodus-Wert geändert werden soll, ferner umfasst:
Bestimmen, ob der WAF-Wert größer als der WAF-Schwellenwert ist;
Bestimmen, ob der Füllfaktor-Wert größer als der Füllfaktor-Schwellenwert ist; und
als Antwort auf das Bestimmen, dass der WAF-Wert größer als der WAF-Schwellenwert ist und/oder der Füllfaktor-Wert größer als der Füllfaktor-Schwellenwert ist:
Ändern des aktuellen Paritätsmodus-Werts in einen nächsten Paritätsmodus-Wert der Vielzahl von Paritätsmodus-Werten; und
Ändern des WAF-Schwellenwerts und des Füllfaktor-Schwellenwerts in einen neuen WAF-Schwellenwert und einen neuen Füllfaktor-Schwellenwert, die mit dem aktuellen Paritätsmodus-Wert assoziiert sind.

7. Verfahren nach einem vorstehenden Anspruch, wobei:
der WAF-Wert ein Wert ist, der eine durch die Speichervorrichtung geschriebene Menge von Daten im Vergleich zu einer durch eine Host-Vorrichtung geschriebenen Menge von Daten angibt; und
der Füllfaktor-Wert ein Wert ist, der eine Menge von gültigen Daten, die in der Speichervorrichtung gespeichert sind, im Verhältnis zu einer Gesamtspeicherkapazität der Speichervorrichtung angibt.

8. Speichervorrichtung, umfassend:
eine Verarbeitungsschaltung (111); und
einen Speicher (109), der kommunikativ mit der Verarbeitungsschaltung (111) verbunden ist, wobei der Speicher (109) dafür konfiguriert ist, computerausführbare Anweisungen zu speichern, die, wenn sie ausgeführt werden, die Verarbeitungsschaltung (111) dazu veranlassen:
als Antwort auf eine Schreibanforderung einen Wert eines Schreibverstärkungsfaktors, WAF, und einen Füllfaktor-Wert, die mit der Speichervorrichtung assoziiert sind, zu bestimmen (301);
einen aktuellen Paritätsmodus-Wert der Speichervorrichtung abzurufen (303);
einen WAF-Schwellenwert und einen Füllfaktor-Schwellenwert, die mit dem aktuellen Paritätsmodus-Wert assoziiert sind, zu bestimmen (305);
zu bestimmen (307), ob der aktuelle Paritätsmodus-Wert auf einen höheren Paritätsmodus-Wert aus einer Vielzahl von Paritätsmodus-Werten geändert werden soll, und zwar auf der Grundlage des WAF-Schwellenwerts, des WAF-Werts, des Füllfaktor-Schwellenwerts und des Füllfaktor-Werts; und
auf der Grundlage von Ergebnissen des Bestimmens Daten in einen Speicherbereich der Speichervorrichtung zu schreiben (309).

9. Speichervorrichtung nach Anspruch 8, wobei
die Vielzahl von Paritätsmodus-Werten in einer logischen Folge gemäß ihren jeweiligen Paritätscode-Raten angeordnet sind; und
jeder der Vielzahl von Paritätsmodus-Werten mit einem entsprechenden WAF-Schwellenwert aus einer Vielzahl von WAF-Schwellenwerten und einem entsprechenden Füllfaktor-Schwellenwert aus einer Vielzahl von Füllfaktor-Schwellenwerten assoziiert ist.

10. Speichervorrichtung nach Anspruch 9, wobei die Vielzahl von Paritätsmodus-Werten in einer aufsteigenden Reihenfolge von Paritätscode-Raten in einer Tabelle angeordnet ist.

11. Speichervorrichtung nach einem der Ansprüche 8-10, wobei der aktuelle Paritätsmodus-Wert Informationen bezüglich einer Anzahl von Dateneinheiten pro physischer Seite und einer dem Paritätsmodus-Wert entsprechenden Anzahl von Paritätsbits einschließt.

12. Speichervorrichtung nach einem der Ansprüche 8-11, wobei die Verarbeitungsschaltung (111) ferner dazu veranlasst wird:
ein Seitenformat mindestens eines Blocks auf der Grundlage des aktuellen Paritätsmodus-Werts zu ändern;
auf der Grundlage des Seitenformats mindestens einen Block der Speichervorrichtung für die Datenspeicherung zuzuteilen; und
die Daten in den mindestens einen zugeteilten Block zu schreiben.

13. Speichervorrichtung nach einem der Ansprüche 8-12, wobei die Verarbeitungsschaltung (111) ferner dazu veranlasst wird, zu bestimmen, ob der aktuelle Paritätsmodus-Wert auf den höheren Paritätsmodus-Wert geändert werden soll, und zwar durch:
Bestimmen, ob der WAF-Wert größer als der WAF-Schwellenwert ist;
Bestimmen, ob der Füllfaktor-Wert größer als der Füllfaktor-Schwellenwert ist; und
als Antwort auf das Bestimmen, dass WAF-Wert größer als der WAF-Schwellenwert ist und der Füllfaktor-Wert größer als der Füllfaktor-Schwellenwert ist:
Ändern des aktuellen Paritätsmodus-Werts in einen nächsten Paritätsmodus-Wert der Vielzahl von Paritätsmodus-Werten, und
Ändern des WAF-Schwellenwerts und des Füllfaktor-Schwellenwerts in einen neuen WAF-Schwellenwert und einen neuen Füllfaktor-Schwellenwert, die mit dem aktuellen Paritätsmodus-Wert assoziiert sind.

14. Speichervorrichtung nach einem der Ansprüche 8-13, wobei:
der WAF-Wert ein Wert ist, der eine durch die Speichervorrichtung geschriebene Menge von Daten im Vergleich zu einer durch eine Host-Vorrichtung geschriebenen Menge von Daten angibt; und
der Füllfaktor-Wert ein Wert ist, der eine Menge von gültigen Daten, die in der Speichervorrichtung gespeichert sind, im Verhältnis zu einer Gesamtspeicherkapazität der Speichervorrichtung angibt.

15. Speichervorrichtung nach einem der Ansprüche 8-14, wobei die Verarbeitungsschaltung (111) ferner dazu veranlasst wird:
die Schreibanforderung zu empfangen; und
auf der Grundlage der Schreibanforderung zu bestimmen, ob ein Trigger erreicht worden ist,
wobei das Bestimmen des WAF-Werts und des Füllfaktor-Werts, die mit der Speichervorrichtung assoziiert sind, als Antwort auf das Erreichen des Triggers erfolgt.

## Revendications

1. Procédé d'écriture de données dans un dispositif de stockage, mis en œuvre par le dispositif de stockage, comprenant :
la détermination (301) d'une valeur de facteur d'amplification d'écriture, WAF, et d'une valeur de facteur de remplissage associées au dispositif de stockage en réponse à une demande d'écriture ;
la récupération (303) d'une valeur de mode de parité actuel du dispositif de stockage ;
la détermination (305) d'un seuil WAF et d'un seuil de facteur de remplissage associés à la valeur de mode de parité actuel ;
la détermination (307) du fait de savoir s'il convient de changer la valeur de mode de parité actuel pour une valeur de mode de parité supérieure parmi une pluralité de valeurs de mode de parité sur la base du seuil WAF, de la valeur WAF, du seuil de facteur de remplissage et de la valeur de facteur de remplissage ; et
l'écriture (309) de données dans une zone de stockage du dispositif de stockage sur la base des résultats de la détermination.

2. Procédé selon la revendication 1, dans lequel
la pluralité de valeurs de mode de parité sont agencées selon une séquence logique en fonction de leurs taux de codage de parité respectifs ; et
chacune de la pluralité de valeurs de mode de parité est associée à un seuil WAF correspondant parmi une pluralité de seuils WAF et à un seuil de facteur de remplissage correspondant parmi une pluralité de seuils de facteur de remplissage.

3. Procédé selon la revendication 2, dans lequel la pluralité de valeurs de mode de parité sont agencées dans un ordre croissant de taux de codage de parité dans un tableau.

4. Procédé selon une quelconque revendication précédente, dans lequel la valeur de mode de parité actuel inclut des informations concernant un nombre d'unités de données par page physique et un nombre de bits de parité correspondant à la valeur de mode de parité.

5. Procédé selon une quelconque revendication précédente, dans lequel l'écriture (309) de données dans la zone de stockage sur la base de la valeur de mode de parité actuel comprend en outre :
la modification d'un format de page d'au moins un bloc sur la base de la valeur de mode de parité actuel ;
l'allocation d'au moins un bloc du dispositif de stockage au stockage de données sur la base du format de page ; et
l'écriture des données dans le au moins un bloc alloué.

6. Procédé selon une quelconque revendication précédente, dans lequel la détermination (307) de savoir s'il convient de changer la valeur de mode de parité actuel pour une valeur de mode de parité supérieure comprend en outre :
la détermination du fait que la valeur WAF est ou non supérieure au seuil WAF ;
la détermination du fait que la valeur de facteur de remplissage est ou non supérieure au seuil de facteur de remplissage ; et
en réponse au fait que la valeur WAF est supérieure au seuil WAF et/ou que la valeur de facteur de remplissage est supérieure au seuil de facteur de remplissage :
le changement de la valeur de mode de parité actuel pour une valeur de mode de parité suivante parmi la pluralité de valeurs de mode de parité ; et
le changement du seuil WAF et du seuil de facteur de remplissage pour un nouveau seuil WAF et un nouveau seuil de facteur de remplissage associés à la valeur de mode de parité actuel.

7. Procédé selon une quelconque revendication précédente, dans lequel :
la valeur WAF est une valeur indiquant une quantité de données écrites par le dispositif de stockage en comparaison avec une quantité de données écrites par un dispositif hôte ; et
la valeur de facteur de remplissage est une valeur indiquant une quantité de données valides stockées dans le dispositif de stockage par rapport à une capacité de stockage totale du dispositif de stockage.

8. Dispositif de stockage, comprenant :
des circuits de traitement (111) ; et
une mémoire (109) couplée de manière communicative aux circuits de traitement (111), dans lequel la mémoire (109) est configurée pour stocker des instructions exécutables par ordinateur qui, lorsqu'elles sont exécutées, amènent les circuits de traitement (111) à :
déterminer (301) une valeur de facteur d'amplification d'écriture, WAF, et une valeur de facteur de remplissage associées au dispositif de stockage en réponse à une demande d'écriture ;
récupérer (303) une valeur de mode de parité actuel du dispositif de stockage ;
déterminer (305) un seuil WAF et un seuil de facteur de remplissage associés à la valeur de mode de parité actuel ;
déterminer (307) s'il convient de changer la valeur de mode de parité actuel pour une valeur de mode de parité supérieure parmi une pluralité de valeurs de mode de parité sur la base du seuil WAF, de la valeur WAF, du seuil de facteur de remplissage et de la valeur de facteur de remplissage ; et
écrire (309) des données dans une zone de stockage du dispositif de stockage sur la base des résultats de la détermination.

9. Dispositif de stockage selon la revendication 8, dans lequel
la pluralité de valeurs de mode de parité sont agencées selon une séquence logique en fonction de leurs taux de codage de parité respectifs ; et
chacune de la pluralité de valeurs de mode de parité est associée à un seuil WAF correspondant parmi une pluralité de seuils WAF et à un seuil de facteur de remplissage correspondant parmi une pluralité de seuils de facteur de remplissage.

10. Dispositif de stockage selon la revendication 9, dans lequel la pluralité de valeurs de mode de parité sont agencées dans un ordre croissant de taux de codage de parité dans un tableau.

11. Dispositif de stockage selon l'une quelconque des revendications 8-10, dans lequel la valeur de mode de parité actuel inclut des informations concernant un nombre d'unités de données par page physique et un nombre de bits de parité correspondant à la valeur de mode de parité.

12. Dispositif de stockage selon l'une quelconque des revendications 8-11, dans lequel les circuits de traitement (111) sont en outre amenés à :
modifier un format de page d'au moins un bloc sur la base de la valeur de mode de parité actuel ;
allouer au moins un bloc du dispositif de stockage au stockage de données sur la base du format de page ; et
écrire les données dans le au moins un bloc alloué.

13. Dispositif de stockage selon l'une quelconque des revendications 8-12, dans lequel les circuits de traitement (111) sont en outre amenés à déterminer s'il convient de changer la valeur de mode de parité actuel pour la valeur de mode de parité supérieure par :
la détermination du fait que la valeur WAF est ou non supérieure au seuil WAF ;
la détermination du fait que la valeur de facteur de remplissage est ou non supérieure au seuil de facteur de remplissage ; et
en réponse au fait que la valeur WAF est supérieure au seuil WAF et que la valeur de facteur de remplissage est supérieure au seuil de facteur de remplissage :
le changement de la valeur de mode de parité actuel pour une valeur de mode de parité suivante parmi la pluralité de valeurs de mode de parité ; et
le changement du seuil WAF et du seuil de facteur de remplissage pour un nouveau seuil WAF et un nouveau seuil de facteur de remplissage associés à la valeur de mode de parité actuel.

14. Dispositif de stockage selon l'une quelconque des revendications 8-13, dans lequel :
la valeur WAF est une valeur indiquant une quantité de données écrites par le dispositif de stockage en comparaison avec une quantité de données écrites par un dispositif hôte ; et
la valeur de facteur de remplissage est une valeur indiquant une quantité de données valides stockées dans le dispositif de stockage par rapport à une capacité de stockage totale du dispositif de stockage.

15. Dispositif de stockage selon l'une quelconque des revendications 8-14, dans lequel les circuits de traitement (111) sont en outre amenés à :
recevoir la demande d'écriture ; et
déterminer si un déclencheur a été atteint sur la base de la demande d'écriture,
dans lequel la détermination de la valeur WAF et de la valeur de facteur de remplissage associées au dispositif de stockage est effectuée en réponse au fait que le déclencheur a été atteint.
